# EUROPEAN PATENT SPECIFICATION

(11) **EP 3 319 130 B1**
(45) Date of publication and mention of the grant of the patent: **27.05.2020**
(21) Application number: 16821166.2
(22) Date of filing: 09.06.2016
(51) Int. Cl.: H01L 31/049, B32B 27/32, B32B 27/18, B32B 27/30, B32B 27/36

(54) **SEALING MATERIAL SHEET FOR SOLAR CELL MODULES AND SEALING MATERIAL-INTEGRATED BACKSIDE PROTECTIVE SHEET USING SAME**
DICHTUNGSMATERIALSCHICHT FÜR SOLARZELLENMODULE UND RÜCKSEITIGE SCHUTZFOLIE MIT INTEGRIERTEM DICHTUNGSMATERIAL DAMIT
FEUILLE DE MATÉRIAU D'ÉTANCHÉITÉ POUR MODULES DE CELLULE SOLAIRE, ET FEUILLE DE PROTECTION ARRIÈRE À MATÉRIAU D'ÉTANCHÉITÉ INTÉGRÉ QUI L'UTILISE

(30) Priority: 03.07.2015 JP 2015134736; 03.07.2015 JP 2015134823
(43) Date of publication of application: 09.05.2018
(73) Proprietor: Dai Nippon Printing Co., Ltd., Tokyo 162-8001 (JP)
(72) Inventor: SHIRAHIGE, Yasushi, Tokyo 162-8001 (JP); TAMAKI, Hiroaki, Tokyo 162-8001 (JP); HAYASHI, Shinji, Tokyo 162-8001 (JP)
(74) Representative: Hoffmann Eitle
(86) International application number: PCT/JP2016/067211
(87) International publication number: WO 2017/006695

(56) References cited:
- WO-A1-00/40407
- WO-A1-2015/008614
- WO-A1-2015/046017
- WO-A1-2016/121990
- JP-A- 2007 335 853
- JP-A- 2014 199 877
- JP-A- 2014 216 345
- JP-A- 2014 241 391
- JP-A- 2015 070 220

## Description

### TECHNICAL FIELD

The present invention relates to a sealing material sheet for a solar-cell module and a sealing material-integrated rear-surface protecting sheet using the same.

### BACKGROUND ART

Conventionally, as the layer constitution of a solar-cell module, it is common to laminate, from the side of the light receiving surface, a transparent front substrate constituted of glass, a light receiving surface side sealing material sheet, a solar cell element, a non-light receiving surface side sealing material sheet, and a rear-surface protecting sheet in order.

A resin sheet constituted of an ethylene-vinyl acetate copolymer resin (EVA) is the most commonly used as a sealing material sheet to be used in a solar-cell module from the viewpoints of processability, workability, preparation cost, and others. However, an EVA resin tends to slowly decompose as it is used for a long period of time, and thus, deteriorates in the solar-cell module, thereby having the possibility of decreasing strength or generating acetic acid gas affecting the solar cell element. Therefore, a sealing material sheet for a solar-cell module, which is formed by using a polyolefin-based resin such as polyethylene instead of an EVA resin, has been suggested (see Patent Document 1 and 2).

Here, the transparency and flexibility of the sealing material sheet mainly constituted of a polyethylene-based resin can be commonly improved by decreasing the density thereof. However, a decrease in density causes problems such as excessive flowing at the time of heating processing and insufficient heat resistance of the base resin leading to the risk of product deterioration in long-term use under a high temperature environment.

As an adverse effect of excessive flowing at the time of the above-described heating processing of the sealing material sheet, for example, there is a problem of contamination of the vacuum laminator. In other words, even when a sealing material sheet is previously integrated with a rear-surface protecting sheet and used as a sealing material-integrated rear-surface protecting sheet, only the sealing material excessively flows at the time of lamination processing for integrating the sheets into a solar-cell module, and there is a problem that the facility is contaminated as the molten resin derived from the sealing material which has protruded around the rear-surface protecting sheet contaminates the laminator.

In the sealing materials of Patent Document 1 and Patent Document 2, the heat resistance is imparted by a crosslinking agent. For example, about 1% of a crosslinking agent is added in Patent Document 1 and a crosslinking agent in an amount to have a gel fraction of 30% or more is added in Patent Document 2 as well. In this case, the heat resistance is surely improved but it is difficult to maintain the flexibility to be required for a sealing material sheet in order to secure the solar cell element protecting performance. Moreover, the film formation ability decreases as the crosslinking progresses during molding. Therefore, it is required to carry out molding at a low temperature and to carry out the crosslinking reaction again after molding as in Patent Document 1, and it is strongly required to further improve the productivity.
Patent Document 1: Japanese Unexamined Patent Application, Publication No. 2000-91611
Patent Document 2: Japanese Unexamined Patent Application, Publication No. 2009-10277

### DISCLOSURE OF THE INVENTION

### Problems to be Solved by the Invention

An object of the present invention is to provide a sealing material sheet for a solar-cell module which is a sealing material sheet mainly using a polyethylene-based resin and has both flexibility and heat resistance in a well-balanced manner so that the above-described contamination of the vacuum laminator at the time of preparation of a solar-cell module can be avoided, and a sealing material-integrated rear-surface protecting sheet using the same.

### Means for Solving the Problems

The inventors of the present invention have conducted a thorough investigation to solve the problems described above. As a result, the inventors have found that it is possible to achieve the above object as a polyethylene-based sealing material sheet for a solar-cell module has a multi-layered structure including a core layer and a skin layer and only the core layer includes another resin having relatively higher heat resistance within a predetermined amount range. Thus, the inventors have finally completed the present invention.
(1) A sealing material sheet for a solar-cell module, which is a multi-layered sheet having a core layer and a skin layer and in which the core layer includes polypropylene at 5% by mass to 40% by mass in a content ratio with respect to whole resin components in the core layer and has a content of low-density polyethylene having a density of 0.910 g/cm³ to 0.940 g/cm³ is 60% by mass to 95% by mass, the polypropylene having an MFR ranging from 5 - 125 g/10 min. at a temperature of 230°C and a load of 2.16 kg (JIS7210), the skin layer includes low-density polyethylene having a density of 0.880 g/cm³ to 0.910 g/cm³ at 80% by mass to 100% by mass in a content ratio with respect to whole resin components in the skin layer but does not include polypropylene, and a thickness of the sealing material sheet is 200 µm to 400 µm.
(2) The sealing material sheet described in the above (1), in which a thickness of the sealing material sheet is 250 µm to 350 µm.
(3) The sealing material sheet described in the above (1) or (2), which is a multi-layered sheet having a three-layered structure of skin/core/skin, in which a colored pigment is included in one skin layer and/or a core layer, and a colored pigment is not included in an outermost surface of the other skin layer.
(4) A sealing material sheet for a solar-cell module, which is a multi-layered sheet having a core layer and a skin layer and in which a content of low-density polyethylene having a density of 0.910 g/cm³ to 0.940 g/cm³ is 60% by mass to 95% by mass in a content ratio with respect to whole resin components in the core layer, the skin layer includes low-density polyethylene having a density of 0.880 g/cm³ to 0.910 g/cm³ at 80% by mass to 100% by mass in a content ratio with respect to whole resin components in the skin layer, a thickness of the sealing material sheet is 200 µm to 400 µm, and in a thermomechanical analysis (TMA) curve which is obtained in a TMA test under the following conditions and indicates relationship between a predetermined temperature range and an indentation depth of a needle into the sealing material sheet, the indentation depth of a needle at a temperature of 150°C in the TMA curve is 20% to 90% of a film thickness of the sealing material sheet. (TMA test: a ϕ10 mm sealing material sheet is set in a TMA apparatus, and a constant pressure of an indentation pressure 50 kPa is applied to a ϕ1 mm needle, a temperature is raised from room temperature to 150°C at a rate of temperature rise of 5°C/min, and an indentation depth of the needle at that time is measured.)
(5) The sealing material sheet described in the above (4), in which the core layer of the sealing material sheet includes polypropylene at 15% by mass to 40% by mass with respect to whole resin components in a core layer composition, the polypropylene having an MFR ranging from 5 - 125 g/10 min. at a temperature of 230°C and a load of 2.16 kg (JIS7210).
(6) A sealing material-integrated rear-surface protecting sheet for a solar-cell module including the sealing material sheet described in any one of the above (1) to (5) and a rear-surface protecting sheet laminated in such a manner that the skin layer is exposed to an outermost layer side.
(7) The sealing material-integrated rear-surface protecting sheet described in the above (6), in which the rear-surface protecting sheet is constituted to include a polyethylene terephthalate layer and/or a hydrolysis resistant polyethylene terephthalate layer.
(8) The sealing material-integrated rear-surface protecting sheet described in the above (6) or (7), in which a thickness of the sealing material-integrated rear-surface protecting sheet is 300 µm to 600 µm.
(9) A solar-cell module including the sealing material-integrated rear-surface protecting sheet described in any one of the above (6) to (8) laminated on a non-light receiving surface side of a solar cell element in such a manner that the skin layers face each other.

### Effects of the Invention

According to the present invention, it is possible to provide a sealing material sheet for a solar-cell module which is a sealing material sheet mainly using a polyethylene-based resin and has both flexibility and heat resistance in a well-balanced manner so that the above-described contamination of the vacuum laminator at the time of preparation of a solar-cell module can be avoided, and a sealing material-integrated rear-surface protecting sheet using the same.

### BRIEF DESCRIPTION OF THE DRAWINGS

Fig. 1 is a schematic cross-sectional view illustrating the layer constitution of a sealing material sheet of the present invention.
Fig. 2 is a schematic cross-sectional view illustrating the layer constitution of a sealing material-integrated rear-surface protecting sheet using the sealing material sheet of the present invention.
Fig. 3 is a schematic cross-sectional view illustrating an example of the layer constitution of a solar-cell module using the sealing material-integrated rear-surface protecting sheet of the present invention.
Fig. 4 is a schematic cross-sectional view illustrating an example of the layer constitution of a conventional general solar-cell module.
Fig. 5 is a graph illustrating the relationship between the temperature (°C) and the indentation depth (%) of a needle into the sealing material sheet with respect to the thickness of the sealing material sheet in a thermomechanical analysis test (TMA test) of sealing material sheets in Examples and Comparative Examples.

### PREFERRED MODE FOR CARRYING OUT THE INVENTION

Hereinafter, details of a sealing material sheet, a sealing material-integrated rear-surface protecting sheet using the same, and a solar-cell module using these of the present invention will be described. The present invention is not limited to the embodiments to be described below.

### <Basic Constitution of Solar-Cell Module>

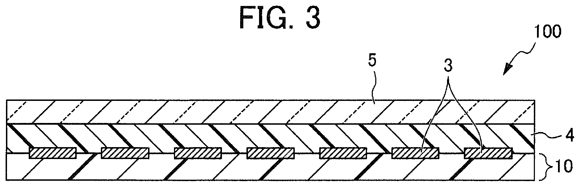

First, the basic constitution of a solar-cell module 100 using a sealing material-integrated rear-surface protecting sheet to be constituted to include a sealing material sheet of the present invention will be described with reference to Fig. 3. The solar-cell module 100 is constituted by laminating, from the non-light receiving surface side, a sealing material-integrated rear-surface protecting sheet 10 of the present invention, a solar cell element 3, a light receiving surface side sealing material sheet 4, and a transparent front substrate 5 to be disposed as the outermost layer on the light receiving surface side in order.

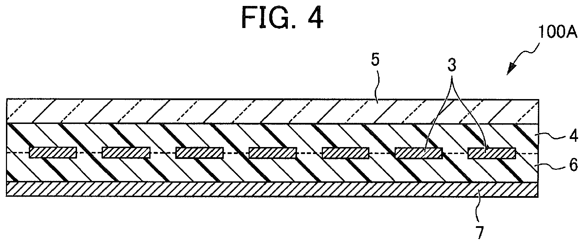

Here, Fig. 4 illustrates the layer constitution of a conventional general solar-cell module (solar-cell module 100A). The conventional solar-cell module 100A is constituted by laminating, from the non-light receiving surface side, a rear-surface protecting sheet 7, a non-light receiving surface side sealing material sheet 6, a solar cell element 3, a light receiving surface side sealing material sheet 4, and a transparent front substrate 5 to be disposed as the outermost layer on the light receiving surface side in order.

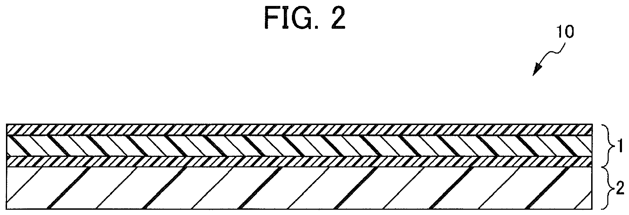

The sealing material-integrated rear-surface protecting sheet 10 of the present invention is a multi-layered sheet constituted by integrally laminating the sealing material sheet 1 of the present invention capable of being thinned while maintaining heat resistance and the rear-surface protecting sheet 2 having barrier properties (see Fig. 2). Therefore, in the solar-cell module 100 using this, it is possible to further decrease the thickness of the solar-cell module than the conventional general solar-cell module 100A in which a sealing material sheet of a conventional product is laminated on both surfaces of the solar cell element 3.

As the solar cell element 3 to be used in the solar-cell module 100, it is possible to use various conventionally known solar cell elements without any particular limitation, for example, an amorphous silicon type, a crystalline silicon type, a CdTe type, a CIS type, a GaAs type, and others.

The light receiving surface side sealing material sheet 4 is a resin sheet to be disposed in the solar-cell module 100 so as to cover the surface of the solar cell element 3 mainly in order to protect the solar cell element 3 from external impact. As the resin base material for forming the light receiving surface side sealing material sheet 4, it is possible to appropriately use a thermoplastic resin such as a polyethylene-based resin such as an ethylene-vinyl acetate copolymer resin (EVA), an ionomer, polyvinyl butyral (PVB), or polyethylene.

The transparent front substrate 5 is generally a glass substrate. The transparent front substrate 5 may also be other members as long as it maintains the weather resistance, impact resistance, and durability of the solar-cell module 100 and transmits sunlight at a high transmittance.

For example, as a general aspect of the conventional solar-cell module 100A (Fig. 4), the total thickness of the resin base material layer constituted to include the sealing material sheet and rear-surface protecting sheet to be laminated on the non-light receiving surface side of the solar cell element 3 is about 500 µm to 800 µm since the thickness of the rear-surface protecting sheet 7 is about 70 µm to 200 µm and the thickness of the non-light receiving surface side sealing material sheet 6 is about 400 µm to 600 µm. On the contrary, in the solar-cell module 100 (Fig. 3) of the present invention, the total thickness of the sealing material-integrated rear-surface protecting sheet 10 to be laminated on the non-light receiving surface side of the solar cell element 3 can be set to about 300 µm to 600 µm. In addition, it is possible to further decrease the total thickness of the solar-cell module by disposing the sealing material sheet 1 in an aspect not to include a colored pigment as the light receiving surface side sealing material sheet.

### <Sealing Material Sheet>

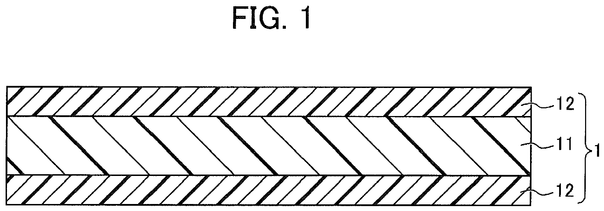

The sealing material sheet 1 of the present invention is a multi-layered sheet having a core layer and a skin layer. The sealing material sheet 1 may have layer constitution in which a skin layer 12 is laminated on only one surface of a core layer 11, but it is preferable to have layer constitution in which the skin layer 12 is laminated on both surfaces of the core layer 11 as illustrated in Fig. 1. In any constitution described above, the sealing material sheet 1 can respond to the requests for thinning of the solar-cell module while maintaining various kinds of required physical properties such as heat resistance, thermal processing suitability, flexibility, and substrate adhesion to be required for a sealing material sheet for a solar-cell module by blending the respective resin composition components to be described below for every layer at optimal composition.

The thickness of the sealing material sheet 1 may be 200 µm to 400 µm. In addition, the thickness of the sealing material sheet 1 is more preferably in the range of 250 µm to 350 µm. When the thickness of the sealing material sheet 1 is 200 µm or more, it is possible to sufficiently maintain various required physical properties in addition to the above-described heat resistance. Incidentally, when the sealing material sheet 1 is the sealing material sheet 1 having a three-layered structure in which the skin layer 12 is laminated on both surfaces of the core layer 11, the thickness ratio among the respective layers is in the range of 1 : 3 : 1 to 1 : 30 : 1 in a thickness ratio of skin : core : skin.

### [Core Layer]

The core layer 11 mainly has a function to impart heat resistance and proper rigidity to the sealing material sheet 1. The core layer 11 includes low-density polyethylene having a density of 0.910 g/cm³ to 0.940 g/cm³ at 60% by mass to 95% by mass with respect to the whole resin components in the core layer composition. In addition, it is preferable that the core layer 11 further includes a heat resistant resin (hereinafter, this resin is also simply referred to as a "heat resistant resin") having higher heat resistance than the above-described low-density polyethylene from the viewpoint of preventing contamination of the laminator due to the melting of the resin derived from the sealing material sheet at the time of lamination processing. Examples of such a heat resistant resin may include polypropylene. In other words, the core layer 11 is a layer constituted of a core layer composition in which a heat resistant resin such as polypropylene is mixed with a polyethylene-based resin to be used as a base resin within a predetermined content ratio range.

The thickness of the core layer 11 is not particularly limited, but it is preferably 100 µm to 240 µm. When the thickness of the core layer 11 is 100 µm or more, it is possible to impart favorable dimensional stability to the sealing material sheet 1. In addition, when the thickness of the core layer 11 is 240 µm or less, it is possible to impart sheet conveying suitability at the time of lamination processing to the sealing material sheet 1.

### (Core Layer Composition)

The core layer composition for forming the core layer 11 includes a low-density polyethylene-based resin having a density of 0.910 g/cm³ to 0.940 g/cm³ as a base resin. The content ratio of this low-density polyethylene-based resin with respect to the whole resin components in the core layer composition may be 60% by mass to 95% by mass and is preferably 75% by mass to 85% by mass.

Moreover, the core layer composition further includes a heat resistant resin in a predetermined amount range in addition to the above-described low-density polyethylene to serve as a base resin. Specifically, as a heat resistant resin, polypropylene is included at preferably 5% by mass to 40% by mass, more preferably 10% by mass to 30% by mass, and still more preferably 10% by mass to 25% by mass in the content ratio with respect to the whole resin components in the core layer composition. The core layer 11 constituted of such a core layer composition is a layer to mainly function as a layer to impart heat resistance and dimensional stability to the sealing material sheet 1.

As polypropylene to be included in the core layer composition as a heat resistant resin, it is more preferable to use a homo-polypropylene (homo PP) resin. Homo PP is a polymer constituted only of simple polypropylene and has high crystallinity, and it thus has higher rigidity than block PP and random PP. It is possible to further enhance the dimensional stability of the sealing material sheet 1 by using this as an additive resin to the core layer composition. In addition, it is preferable that MFR of homo PP at 230°C is 5 g/10 min to 125 g/10 min. When the MFR is less than 5 g/10 min, the molecular weight increases, the rigidity increases too high, and it is thus impossible to secure preferred sufficient flexibility of the sealing material sheet 1 even by the physical properties of the skin layer 12. In addition, when the MFR exceeds 125 g/10 min, the fluidity at the time of heating is not sufficiently suppressed and it is thus impossible to sufficiently impart heat resistance and dimensional stability to the sealing material sheet 1 as described above. Incidentally, "MFR" in the present specification means a value of MFR at 190°C and a load of 2.16 kg measured in conformity to JIS 7210 (however, MFR of the polypropylene resin is a value of MFR at 230°C and a load of 2.16 kg measured in conformity to JIS 7210) unless otherwise specified.

However, polypropylene has much higher rigidity than low-density polyethylene to serve as a base resin even though it is any of the above structures. Therefore, for example, when polypropylene is added to the core layer composition at more than 40% by mass to exceed the above-described appropriate added amount range, the physical properties of polypropylene are excessively dominant in the core layer 11 and favorable flexibility of the sealing material sheet 1 cannot be secured as a whole even by the physical properties of the skin layer 12. It is thus preferable to add polypropylene in a limited amount within the above range when polypropylene is added to the core layer composition as a heat resistant resin.

By mixing a heat resistant resin such as polypropylene in the above content range, it is possible to impart favorable heat resistance to the sealing material sheet 1 even when the sealing material sheet is formed into a thin sheet of 400 µm or less. In addition, by imparting sufficient heat resistance to the sealing material sheet 1, it is also possible to suppress the occurrence of curl deformation of the sealing material sheet, which is likely to be a problem particularly at the time of vacuum lamination processing in the preparation of the solar-cell module.

The core layer 11 can further include an inorganic filler. This enhances the rigidity of the core layer 11 and makes it possible to suppress the occurrence of undesirable curl deformation of the sealing material sheet 1. As such an inorganic filler, it is possible to use talc (hydrous magnesium silicate) or titanium oxide, and as others, calcium carbonate, carbon black, titanium black, a Cu-Mn-based composite oxide, and a Cu-Cr-Mn-based composite oxide, or zinc oxide, aluminum oxide, iron oxide, silicon oxide, barium sulfate, calcium carbonate, titanium yellow, chrome green, ultramarine blue, aluminum powder, mica, and barium carbonate. It is not essential to include an inorganic filler in the core layer composition for forming the core layer 11, and the content of the inorganic filler may be in the range of 0% by mass to 30% by mass with respect to the resin component in the core layer composition.

Incidentally, when the sealing material-integrated rear-surface protecting sheet is required to have a colored appearance, titanium oxide may be further included as a white pigment and carbon black may be further included as a black pigment among the above-described inorganic fillers since these have excellent weather resistance, are easily formed into a coating material, and are easily available including the price. It is preferable to include these colored pigments from the viewpoint of improving the power generation efficiency by re-reflection of solar rays or responding to the design requirements.

### [Skin Layer]

The skin layer 12 is a layer to be disposed on one outermost layer or both outermost layers of the sealing material sheet 1. In the solar-cell module 100, the skin layer 12 serves as a close contact surface with the surface on the non-light receiving surface side of the solar cell element 3 and the light receiving surface side sealing material sheet 4 or a close contact surface with the rear-surface protecting sheet 2 when forming a sealing material-integrated rear-surface protecting sheet 10. Particularly in the former case, the skin layer 12 contributes to the improvement in adhesion of the sealing material sheet 1 and the followability (hereinafter referred to as "molding characteristics") to irregularities of other members at the time of lamination processing for integrating the members into a solar-cell module.

The thickness of the skin layer 12 may be appropriately determined in consideration of the thickness (thinness) to be required for the sealing material sheet 1. As an example, in the case of layer constitution in which the skin layer 12 is laminated on one surface of the core layer 11, the preferred thickness of the skin layer 12 is 3 µm to 150 µm. When the thickness of the skin layer 12 is 3 µm or more, it is possible to impart sufficient adhesion and molding characteristics to the sealing material sheet 1.

When the skin layer 12 is formed on both surfaces of the core layer 11, it is possible to include a colored pigment in either one of the two skin layers 12. In this case, it is preferable that at least the outermost surface of the other skin layer 12 does not include a colored pigment, preferably over substantially the entire layer of the other skin layer. It is preferable that the sealing material sheet 1 having such layer constitution is disposed in the solar-cell module 100 so that one skin layer 12 including a colored pigment faces the rear-surface protecting sheet 2. In the solar-cell module 100, this makes the sealing material sheet 1 exhibit the light reflecting function on the non-light receiving surface side of the solar cell element 3 and thus contribute to the improvement in power generation rate of the solar-cell module 100. At this time, if the other skin layer 12 is set so as not to include a colored pigment, it is possible to decrease the load derived from the pigment to the solar cell element and to suppress the occurrence of cracking of the solar cell element in the lamination step when integrating the members into a solar-cell module. In addition, it is also possible to prevent the wraparound of the white pigment, which causes a decrease in the power generation efficiency in the above lamination step, to the light receiving surface side of the solar cell element. Therefore, it is preferable that the other skin layer 12 does not include a colored pigment.

### (Skin Layer Composition)

The skin layer composition for forming the skin layer 12 includes low-density polyethylene having a density of 0.880 g/cm³ to 0.910 g/cm³ as a base resin. The content ratio of this low-density polyethylene-based resin with respect to the whole resin components in the skin layer composition may be 80% by mass to 100% by mass and is preferably 98% by mass to 100% by mass.

It is preferable that the skin layer composition does not include a heat resistant resin such as polypropylene unlike the core layer composition. The skin layer 12 constituted of such a skin layer composition is a layer to mainly function as a layer to impart molding characteristics and adhesion to the sealing material sheet 1.

In the skin layer composition, it is possible to use low-density polyethylene (LDPE) having the above density range and more preferably linear low-density polyethylene (LLDPE) which is a copolymer of ethylene and an α-olefin and has the above density range. By setting the kind, density range, and content ratio of the adhesion component within the above-described composition range, it is possible to impart preferred flexibility to the sealing material sheet 1 having the skin layer 12.

In addition, it is preferable that the skin layer composition includes silane modified polyethylene at a predetermined proportion. The silane modified polyethylene-based resin is one obtained by graft-polymerizing an ethylenically unsaturated silane compound as a side chain onto linear low-density polyethylene (LLDPE) to serve as a main chain. Such a graft copolymer has a high degree of freedom of silanol groups which contribute to the adhesive force, and thus the adhesion of the sealing material sheet 1 can be further improved.

The grafted amount which is the content of the ethylenically unsaturated silane compound may be appropriately adjusted so that the grafted amount of the ethylenically unsaturated silane compound with respect to 100 parts by mass of the polyethylene-based resin for forming the skin layer is, for example, 0.001 parts by mass to 15 parts by mass, preferably 0.05 parts by mass to 2 parts by mass, and more preferably 0.1 parts by mass to 1.0 parts by mass. The mechanical strength, heat resistance, are excellent when the content of the ethylenically unsaturated silane compound is high, but the elongation in tension, thermal fusibility, tend to be inferior when the content is excessive.

The silane modified polyethylene-based resin can be prepared by, for example, the method described in Japanese Unexamined Patent Application, Publication No. 2003-46105, and by using the resin as a component of a sealing material composition for a solar-cell module, it is possible to stably and inexpensively prepare a solar-cell module which has excellent strength, durability, also has excellent weather resistance, heat resistance, water resistance, light resistance, wind pressure resistance, hail resistance, and other various properties, further has extremely excellent thermal fusibility without being affected by the preparation conditions, such as thermocompression, for the preparation of the solar-cell module, and is suitable for various applications.

As the ethylenically unsaturated silane compound to be graft-polymerized onto linear low-density polyethylene, it is possible to use one or more kinds selected from vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinylpropionyloxysilane, vinyltriacetoxysilane, and vinyltricarboxysilane.

### (Other Components)

The skin layer composition and the core layer composition may further include other components. Examples thereof may include components such as various kinds of weathering master batches for imparting weather resistance to the sealing material sheet 1 and various kinds of fillers, light stabilizers, ultraviolet absorbers, and heat stabilizers. The contents of these differ depending on the particle shape, density, but it is preferable that the contents are each in the range of 0.001% by mass to 5% by mass in the sealing material composition. By including these additives, it is possible to stably improve the mechanical strength of the sealing material sheet 1 over a long period of time and to impart an effect of preventing yellowing, cracking, to the sealing material sheet 1.

### [Sealing Material Sheet (Second Embodiment)]

Here, another preferred embodiment (referred to as a "second embodiment") of the sealing material sheet of the present invention will be described. The sealing material sheet of the second embodiment is a sealing material sheet in which the composition of the base resin in the composition for forming each of the core layer and the skin layer and the total thickness of the sealing material sheet are within predetermined ranges and also it is an essential constitutional requirement that a specific value which can be obtained by subjecting the sealing material sheet to a thermomechanical analysis (TMA) test is within a predetermined range. The sealing material sheet of the second embodiment to be defined in this manner is also a sealing material sheet which can exhibit the same effect as the sealing material sheet 1 described above.

In the sealing material sheet of the second embodiment, the composition of the base resin in the resin composition for forming each layer is the same as that in the sealing material sheet 1. In the sealing material sheet of the second embodiment, the core layer includes low-density polyethylene having a density of 0.910 g/cm³ to 0.940 g/cm³ at 60% by mass to 95% by mass in the content ratio with respect to the whole resin components in the core layer and the skin layer includes low-density polyethylene having a density of 0.880 g/cm³ to 0.910 g/cm³ at 80% by mass to 100% by mass in the content ratio with respect to the whole resin components in the skin layer. Moreover, the total thickness of this sealing material sheet of the second embodiment is also 200 µm to 400 µm in the same manner as in the sealing material sheet 1.

Moreover, the sealing material sheet of the second embodiment becomes the sealing material sheet of the present invention which can exhibit the same effect as the sealing material sheet 1 as the sealing material sheet of the second embodiment satisfies the requirement for the base resin of the above-described material composition and the requirement for the total thickness and also the measured value at a predetermined temperature in a thermomechanical analysis test (hereinafter also referred to as the "TMA test") which indicates the relationship between a predetermined temperature range and the indentation depth of a needle into the sealing material sheet obtained in the thermomechanical analysis (TMA) test under the following conditions is defined in a specific range.

Specifically, in the sealing material sheet of the second embodiment, it is preferable that the indentation depth of a needle at a temperature of 150°C in the TMA curve which indicates the relationship between a predetermined temperature range and the indentation depth of a needle into the sealing material sheet is 20% to 90% of the film thickness of the sealing material sheet in the TMA test. By optimizing the indentation depth of a needle at a temperature of 150°C within this range, the sealing material sheet of the second embodiment has favorable flexibility in the same manner as the sealing material sheet 1 and contamination of the laminator due to melting of the resin in the sealing material sheet at the time of lamination processing can also be prevented.

Here, the TMA test in the present invention refers to a test in which a ϕ10 mm sealing material sheet is set in a TMA apparatus, an indentation pressure of 50 kPa is applied to a ϕ1 mm needle, the temperature is raised to a predetermined temperature range (°C), for example, from room temperature to 150°C at a rate of temperature rise of 5°C/min, and the indentation depth of the needle at that time is measured. As a thermomechanical analysis (TMA) apparatus, for example, TMA/SS7100 manufactured by Hitachi High-Tech Science Corporation can be used. Incidentally, in the present specification, the indentation depth of a needle into the sealing material sheet means the absolute value of the depth of a needle indented into the surface of the sealing material sheet.

By setting the indentation depth of a needle at a temperature of 150°C to 20% or more of the film thickness of the sealing material sheet, more preferable flexibility can be obtained. By setting the indentation depth of a needle to 90% or less, and more preferably 30% to 80% of the film thickness of the sealing material sheet, it is possible to further prevent excessive flowing of the sealing material sheet at the time of heating and to prevent contamination of the laminator due to melting of the resin derived from the sealing material sheet at the time of lamination processing.

### <Sealing Material-Integrated Rear-Surface Protecting Sheet>

As illustrated in Fig. 2, the sealing material-integrated rear-surface protecting sheet 10 is a multi-layered resin sheet constituted by integrally forming the sealing material sheet 1 and the rear-surface protecting sheet 2. The thickness of the sealing material-integrated rear-surface protecting sheet 10 is not particularly limited, but a thickness in the range of about 300 µm to 600 µm may be mentioned as a general example, and an example in which the thickness is in the range of 350 µm to 480 µm may be mentioned as a specific example of a more preferred embodiment. Moreover, the sealing material-integrated rear-surface protecting sheet 10 is disposed and used in the solar-cell module 100 in such a manner that the sealing material sheet 1 faces the non-light receiving surface side of the solar cell element 3.

As the rear-surface protecting sheet 2 which is laminated with the sealing material sheet 1 to constitute the sealing material-integrated rear-surface protecting sheet 10, it is possible to use various kinds of resin sheets which have been conventionally used as a rear-surface protecting sheet for a solar-cell module. As the resin sheet forming the rear-surface protecting sheet 2, for example, it is possible to use various kinds of resin sheets such as a polyethylene-based resin, a cyclic polyolefin-based resin, a polystyrene-based resin, an acrylonitrile-styrene copolymer, an acrylonitrile-butadienestyrene copolymer, a polyvinyl chloride-based resin, a poly (meth)acrylic resin, a polycarbonate-based resin, a polyester-based resin such as polyethylene terephthalate (PET) or polyethylene naphthalate, a polyamide-based resin such as various kinds of nylon, a polyimide-based resin, a polyamideimide-based resin, a polyaryl phthalate-based resin, a silicone-based resin, a polysulfone-based resin, a polyphenylene sulfide-based resin, a polyether sulfone-based resin, a polyurethane-based resin, an acetal-based resin, a cellulose-based resin. Among these, polyethylene terephthalate (PET) can be preferably used from the viewpoints of physical properties and economic efficiency such as insulation performance, mechanical strength, cost, and transparency. In addition, it is possible to particularly preferably use a multi-layered sheet obtained by further laminating hydrolysis resistant PET as the outermost layer in addition to the above PET as the rear-surface protecting sheet 2 from the viewpoint of further improving the mechanical strength and the vapor barrier properties.

The thickness of the rear-surface protecting sheet 2 is not particularly limited, but it may be appropriately determined in the range in which the physical properties such as water vapor barrier properties to be required for the rear-surface protecting sheet 2 can be maintained by taking the thickness to be required for the sealing material-integrated rear-surface protecting sheet 10 into consideration. The thickness of the rear-surface protecting sheet 2 is preferably 50 µm to 300 µm and more preferably 50 µm to 200 µm. It is possible to impart preferable durability and weather resistance to the sealing material-integrated rear-surface protecting sheet 10 as the thickness of the rear-surface protecting sheet 2 is 50 µm or more.

Incidentally, one obtained by further laminating a weathering layer (not illustrated) on one surface, which is supposed to be the outermost layer side at the time of integration with the solar-cell module, can also be preferably used as the rear-surface protecting sheet 2. As the weathering layer, those having excellent weather resistance, heat resistance, light resistance are used. Examples of the base material for forming the weathering layer may include a resin sheet of a fluorine-based resin such as hydrolysis resistant polyethylene terephthalate (hydrolysis resistant PET), PCTFE (polychlorotrifluoroethylene), PFA (tetrafluoroethylene perfluoroalkyl vinyl ·ester copolymer), PTFE (polytetrafluoroethylene), ETFE (tetrafluoroethylene ·ethylene copolymer), or PVDF (polyvinylidene fluoride) or an aluminum sheet. Among those described above, hydrolysis resistant PET can be particularly preferably used. Hydrolysis resistant PET refers to polyethylene terephthalate which has excellent hydrolysis resistance and is described in Japanese Unexamined Patent Application, Publication No. 2012-62380. This hydrolysis resistant PET is polyethylene terephthalate which includes an alkali metal element at 2 ppm to 100 ppm and phosphorus element at 10 ppm to 250 ppm, and it is a resin constituted to include polyoxyalkylene glycol at 2 parts by mass to 20 parts by mass with respect to 100 parts by mass of the polyethylene terephthalate resin composition. Hydrolysis resistant PET has excellent hydrolysis resistance as well as excellent heat resistance and durability to be required for a protecting sheet for a solar-cell module to be disposed on the rear-surface side. In addition, hydrolysis resistant PET can be extremely preferably used as a material for forming the weathering layer of the rear-surface protecting sheet 2 since it has excellent processability and the cost thereof is relatively low.

Incidentally, the weathering layer of the rear-surface protecting sheet 2 may be one obtained by forming a weathering coating layer on the surface of the base material layer by surface processing such as fluorine coating, EB coating, or silica vapor deposition. Furthermore, one obtained by processing a resin sheet having the above-described weather resistance so as to have a predetermined thickness and a required strength can also be used as the rear-surface protecting sheet 2.

It is preferable that integration of the sealing material sheet 1 and the rear-surface protecting sheet 2 in the sealing material-integrated rear-surface protecting sheet 10 is carried out by a dry lamination method to be carried out via an adhesive layer (not illustrated). However, the integration may be carried out by other conventionally known means as long as it is means capable of maintaining the desired adhesion and durability. For example, it is possible to integrate the sealing material sheet 1 and the rear-surface protecting sheet 2 by an extrusion coating lamination method in which a resin composition to be a sealing material sheet is directly extruded onto the surface of the rear-surface protecting sheet 2 by using an extruder to form the sealing material sheet 1 or a sandwich lamination method which is an application form of the extrusion coating lamination method, thereby obtaining the sealing material-integrated rear-surface protecting sheet 10.

### <Method of Preparing Sealing Material-Integrated Rear-Surface Protecting Sheet>

A method of preparing the sealing material-integrated rear-surface protecting sheet of the present invention will be described. The sealing material-integrated rear-surface protecting sheet 10 can be prepared through a "rear-surface protecting sheet forming step" of forming the rear-surface protecting sheet 2, a "sealing material sheet forming step" of forming the sealing material sheet 1, and an "integration step" of laminating the sealing material sheet 1 on the rear-surface protecting sheet 2 and integrating these together.

### (Rear-Surface Protecting Sheet Forming Step)

The rear-surface protecting sheet 2 can be formed by forming a film of the resin material such as PET described above by an extrusion method, a cast molding method, a T die method, a cutting method, an inflation method, another film formation method. Incidentally, the rear-surface protecting sheet 2 may include other additives such as a pigment in addition to the resin material as long as the effect of the present invention is not impaired.

### (Sealing Material Sheet Forming Step)

The sealing material sheet 1 can be obtained by integrally molding the skin layer composition and core layer composition described above by a known co-extrusion method into a multi-layered sheet.

### (Integration Step)

The sealing material-integrated rear-surface protecting sheet 10 of the present invention can be obtained by appropriately laminating the sealing material sheet 1, the rear-surface protecting sheet 2, and, if necessary, a sheet which is formed by the same method and forms another layer and further integrating these together. The integration of the respective sheets can be carried out by a conventionally known dry lamination method. The adhesive for lamination is not particularly limited, a conventionally known adhesive for lamination can be utilized, and a two-part curable adhesive for dry lamination constituted of a urethane-based or epoxy-based main ingredient and a curing agent can be appropriately used. Incidentally, this integration step can also be carried out by an extrusion coating lamination method or a sandwich lamination method which is an application form of the extrusion coating lamination method.

### <Method of Preparing Solar-Cell Module>

The solar-cell module 100 can be prepared by, for example, sequentially laminating members constituted of the transparent front substrate 5, the light receiving surface side sealing material sheet 4, the solar cell element 3, and the sealing material-integrated rear-surface protecting sheet 10, integrating the laminated members by a vacuum aspiration and then, thermocompression-molding the above members in one molding body by a molding method such as a lamination method. For example, in the case of vacuum thermal lamination processing, the lamination temperature is preferably set within the range of 130°C to 180°C. In addition, the lamination time is set preferably within the range of 5 minutes to 20 minutes and particularly preferably within the range of 8 minutes to 15 minutes. The solar-cell module 100 can be prepared by thermocompression-molding the respective layers as one molding body in this manner.

Hereinafter, the present invention will be described more specifically with reference to Examples and Comparative Examples, but the present invention is not limited to the following Examples.

### <Preparation of Sealing Material Sheet>

The sealing material sheets of Examples and Comparative Examples were prepared by using the following materials and the "method of preparing sealing material sheet" described above.

The mixtures in which the following materials were mixed in the respective compositions listed in Table 1 were separately used as the blends for the core layer and the skin layer of the sealing material sheets of Examples and Comparative Examples, respectively. Thereafter, each of these blends was molded into a sheet at an extrusion temperature of 210°C and a taking-up speed of 1.1 m/min using a sheet molder having a ϕ30 mm extruder and a T dice having a width of 200 mm, and then the molded sheets were formed into a three-layered sealing material sheet of skin/core/skin. The total thickness of each sealing material sheet and the thickness of each layer were 50 µm for each skin layer, 200 µm for the core layer, and 300 µm for the layer thickness in any sealing material sheet. Incidentally, in Comparative Example 7, a commercially available ethylene-vinyl acetate copolymer resin (EVA) sheet was used to form a single layer sealing material sheet having a total thickness of 300 µm.

The following raw materials were used as the materials for the sealing material sheet.
Low-density polyethylene 1 (LDPE, marked with "LD1" in the table): density of 0.920 g/cm³ and melting point of 123°C. Low-density polyethylene 2 (LDPE, marked with "LD2" in the table): density of 0.920 g/cm³ and melting point of 105°C. Linear low-density polyethylene (LLDPE, marked with "LLD" in the table): density of 0.898 g/cm³ and melting point of 97°C. Silane modified polyethylene-based resin (marked with "SiPE" in the table): 2 parts by mass of vinyltrimethoxysilane and 0.1 parts by mass of dicumyl peroxide as a radical generating agent (reaction catalyst) were mixed with respect to 98 parts by mass of metallocene-based linear low-density polyethylene (M-LLDPE) having a density of 0.901 g/cm³ and MFR of 1.1 g/10 min, and then, melted and kneaded at 200°C to obtain a silane modified transparent resin having a density of 0.901 g/cm³. Polypropylene (PP, marked with "PP" in the table): homo-polypropylene. Density of 0.900 g/cm³ and melting point of 155°C. MFR of 8.5 g/10 min (230°C).
White pigment: titanium oxide having an average particle diameter of 0.2 µm. Added only to the core layer of all the sealing material sheets of Examples and Comparative Examples at 7 parts by mass per 100 parts by mass of the resin component.
Ultraviolet absorber: trade name KEMISORB 12 manufactured by CHEMIPRO KASEI KAISHA, LTD. Added to each of the sealing material compositions for all the core layers and skin layers of Examples and Comparative Examples at 0.3 parts by mass. Weathering stabilizer: trade name Tinuvin 622SF manufactured by BASF SE. Added to each of the sealing material compositions for all the core layers and skin layers of Examples and Comparative Examples at 0.2 parts by mass.
Antioxidant: trade name Irganox 1076 manufactured by Ciba Japan Ltd. Added to each of the sealing material compositions for all the core layers and skin layers of Examples and Comparative Examples at 0.05 parts by mass.

### <Preparation of Sealing Material-Integrated Rear-Surface Protecting Sheet>

The above-described sealing material sheets of Examples and Comparative Examples and a PET film having a surface subjected to the corona treatment ("Melinex S" manufactured by TEIJIN FILM SOLUTIONS LIMITED, thickness: 125 µm) were laminated by a conventionally known dry lamination method to obtain sealing material-integrated rear-surface protecting sheets of the respective Examples and Comparative Examples.

For each of the sealing material sheets and sealing material-integrated rear-surface protecting sheets of Examples and Comparative Examples, the presence or absence of contamination of the laminator at the time of lamination processing, the cell protecting performance, and the maintenance factor of the power generation efficiency in the case of assuming an actual use environment were measured and evaluated based on the following test methods and evaluation criteria. The results thus obtained are listed in Table 1 and Table 2.

### <Evaluation on Presence or Absence of Contamination of Laminator during Lamination Processing>

White board semi-tempered glass, a solar cell element (cell Q6LTT-200/152 156 mm manufactured by Hanwha Q-CELLS Co., Ltd.) (2 × 2 pieces), the sealing material sheet for the light receiving surface side, and each of the "sealing material-integrated rear-surface protecting sheets" of Examples and Comparative Examples were laminated in the order of the white board semi-tempered glass/sealing material sheet for light receiving surface side/solar cell element/sealing material/sealing material-integrated rear-surface protecting sheet and a vacuum heating lamination treatment was carried out under the following lamination conditions, thereby obtaining the samples for evaluating the solar-cell modules of the respective Examples and Comparative Examples. Immediately after this sample was taken out from the laminator, the hot plate at the bottom of the laminator and the rubber portion of the top plate were visually observed to evaluate the presence or absence of contamination of the laminator at the time of lamination processing. The evaluation results thus obtained are listed in Table 1 as "contamination of laminator".
(Lamination Condition)
Vacuum evacuation: 5.0 minutes
Pressurization (0 kPa to 100 kPa): 1.0 minutes
Pressure maintenance (100 kPa): 10.0 minutes
Temperature: 150°C
(Criteria for Evaluation on Presence or Absence of Contamination of Laminator)
A: There is no resin stain.
B: There is resin stain which can be removed by being stroked back and forth one time with brush attached to laminator.
C: There is resin stain which cannot be removed with above brush.

### <Evaluation on Solar Cell Element Protecting Performance during Lamination Processing>

Each of the above-described samples for evaluating the solar-cell modules was subjected to the measurement by an EL light emission tester and evaluated on the solar cell element protecting performance at the time of lamination processing. The evaluation results thus obtained are listed in Table 1 and Table 2 as "cell protecting performance".
(Criteria for Evaluation on Cell Protecting Performance)
A: There is no crack on entire surface of all solar cell elements.
B: There are cracks on some solar cell elements but light emission can be confirmed on entire surface.
C: There are cracks and there are places at which light emission cannot be confirmed.

### <Evaluation on Long-Term Maintenance Factor of Power Generation Efficiency>

For each of the above-described samples for evaluating the solar-cell modules, the Pmax values before and after a thermal cycle test were measured, the maintenance factor of power generation efficiency was calculated, and the long-term maintenance factor of power generation efficiency was evaluated. Incidentally, the Pmax value is the maximum output value at the operating point at which the output of the solar cell is the highest, and the power generation output of the module before and after the following thermal cycle test was measured based on JIS-C8935-1995. In the thermal cycle, the above sample for evaluation was placed in an oven of which the temperature was changed according to the following predetermined cycle, the power generation efficiency was measured before and after 500 cycles, and the ratio thereof was calculated. As the cycle condition of the oven, the temperature was lowered to -20°C and raised to 90°C, the time to be required for the change of the first-term temperature was set to 5 hours, the time to maintain the temperature was set to 1 hour, and a process in which the temperature was raised from -20°C to 90°C and then lowered from 90°C to -20°C was taken as one cycle. The results thus obtained are listed in Table 1 and Table 2.
A: Maintenance factor of power generation efficiency is 98% or more.
B: Maintenance factor of power generation efficiency is 96% or more.
C: Maintenance factor of power generation efficiency is less than 96%.

### <Thermomechanical Analysis (TMA) Test>

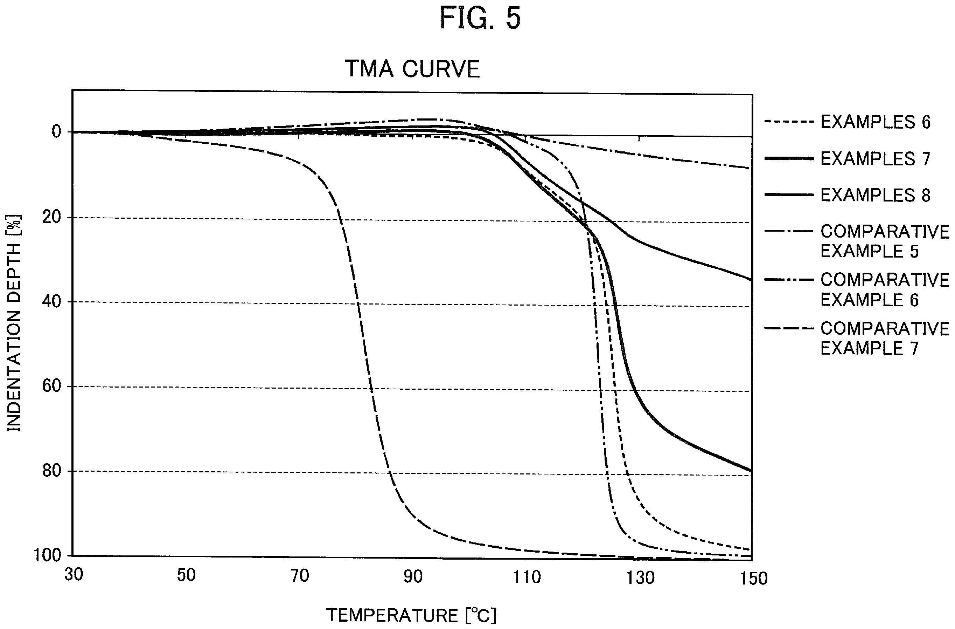

For the sealing material sheets used in the respective sealing material-integrated rear-surface protecting sheets of Examples 6 to 8 and Comparative Examples 5 to 7 among the respective Examples and Comparative Examples, a TMA test was further carried out. Specifically, each of these sealing material sheets was cut into ϕ10 mm, set in a TMA apparatus (TMA/SS7100 manufactured by Hitachi High-Tech Science Corporation), the temperature of the sealing material sheet was raised, and a ϕ1 mm needle was indented from the surface of the sealing material sheet thereinto at a pressure of 50 kPa, and the indentation depth was measured. The rate of temperature rise was 5°C/min, and the temperature was raised from room temperature to 150°C. A graph indicating the relationship between the temperature (°C) and the indentation depth (%) of a needle into the sealing material sheet with respect to the thickness of the sealing material sheet in the TMA test of the sealing material sheets in the respective Examples and Comparative Examples is illustrated in Fig. 5. In addition, the proportion (%) (marked with indentation depth (%) in Table 2) of the indentation depth of a needle at a temperature of 150°C in the TMA curve with respect to the film thickness of the sealing material sheet is listed in Table 2.

**[Table 1]**

| (Melting point°C) | | LD1 | LD2 | LLD | PP | SiLD | EVA | Contaminati on of laminator | Cell protecting performance | Maintenance factor of power generation efficiency |
|---|---|---|---|---|---|---|---|---|---|---|
| | | 123 | 105 | 97 | 155 | 95 | 70 | | | |
| Example 1 | Core | 90.0 | 0.0 | 0.0 | 10.0 | 0.0 | 0.0 | A | A | B |
| | Skin | 0.0 | 0.0 | 85.0 | 0.0 | 15.0 | 0.0 | | | |
| Example 2 | Core | 80.0 | 0.0 | 0.0 | 20.0 | 0.0 | 0.0 | A | A | A |
| | Skin | 0.0 | 0.0 | 85.0 | 0.0 | 15.0 | 0.0 | | | |
| Example 3 | Core | 70.0 | 0.0 | 0.0 | 30.0 | 0.0 | 0.0 | A | B | A |
| | Skin | 0.0 | 0.0 | 85.0 | 0.0 | 15.0 | 0.0 | | | |
| Example 4 | Core | 0.0 | 90.0 | 0.0 | 10.0 | 0.0 | 0.0 | B | A | B |
| | Skin | 0.0 | 0.0 | 85.0 | 0.0 | 15.0 | 0.0 | | | |
| Example 5 | Core | 0.0 | 80.0 | 0.0 | 20.0 | 0.0 | 0.0 | A | A | A |
| | Skin | 0.0 | 0.0 | 85.0 | 0.0 | 15.0 | 0.0 | | | |
| Comparative Example 1 | Core | 100.0 | 0.0 | 0.0 | 0.0 | 0.0 | 0.0 | C | A | C |
| | Skin | 0.0 | 0.0 | 85.0 | 0.0 | 15.0 | 0.0 | | | |
| Comparative Example 2 | Core | 0.0 | 100.0 | 0.0 | 0.0 | 0.0 | 0.0 | C | A | C |
| | Skin | 0.0 | 0.0 | 85.0 | 0.0 | 15.0 | 0.0 | | | |
| Comparative Example 3 | Core | 90.0 | 0.0 | 0.0 | 10.0 | 0.0 | 0.0 | A | C | B |
| | Skin | 0.0 | 0.0 | 75.0 | 10.0 | 15.0 | 0.0 | | | |
| Comparative Example 4 | Core | 40.0 | 0.0 | 0.0 | 60.0 | 0.0 | 0.0 | A | C | A |
| | Skin | 0.0 | 0.0 | 85.0 | 0.0 | 15.0 | 0.0 | | | |

**[Table 2]**

| (Melting point °C) | | LD1 123 | LLD 97 | PP 155 | EVA 70 | Contamination of laminator | Cell protecting performance | Maintenanc e factor of power generation efficiency | Indentation depth (%) |
|---|---|---|---|---|---|---|---|---|---|
| Example 6 | Core | 90.0 | 0.0 | 10.0 | 0.0 | B | A | B | 97 |
| | Skin | 0.0 | 100.0 | 0.0 | 0.0 | | | | |
| Example 7 | Core | 80.0 | 0.0 | 20.0 | 0.0 | A | A | A | 79 |
| | Skin | 0.0 | 100.0 | 0.0 | 0.0 | | | | |
| Example 8 | Core | 70.0 | 0.0 | 30.0 | 0.0 | A | A | A | 34 |
| | Skin | 0.0 | 100.0 | 0.0 | 0.0 | | | | |
| Comparative Example 5 | Core | 0.0 | 70.0 | 30.0 | 0.0 | A | C | A | 7 |
| | Skin | 0.0 | 70.0 | 30.0 | 0.0 | | | | |
| Comparative Example 6 | Core | 100.0 | 0.0 | 0.0 | 0.0 | B | A | B | 99 |
| | Skin | 0.0 | 100.0 | 0.0 | 0.0 | | | | |
| Comparative Example 7 | Single layer | 0.0 | 0.0 | 0.0 | 100.0 | A | C | A | 100 |

From Table 1 and Table 2, it can be seen that the sealing material sheet of the present invention and the sealing material-integrated rear-surface protecting sheet using the same have both flexibility and heat resistance in a well-balanced manner, thus are also preferable from the viewpoint of productivity, and have favorable basic performance, the solar cell element protecting performance as a sealing material, and can sufficiently contribute to long-term weather resistance of the solar-cell module.

Furthermore, it can be seen from Table 2 that the sealing material-integrated rear-surface protecting sheets of Examples 7 and 8 using a sealing material sheet in which the indentation depth of a needle at a temperature of 150°C in the TMA curve is 20% to 90% of the film thickness of the sealing material sheet have all the laminator contamination preventing function, the cell protecting function, and the long-term weather resistance of the solar-cell module in a particularly preferred manner.

### EXPLANATION OF REFERENCE NUMERALS

- 1: Sealing material sheet
- 11: Core layer
- 12: Skin layer
- 2 and 7: Rear-surface protecting sheet
- 3: Solar cell element
- 4: Light-receiving surface side sealing material sheet
- 5: Transparent front substrate
- 6: Non-light receiving surface side sealing material sheet
- 10: Sealing material-integrated rear-surface protecting sheet
- 100: Solar-cell module

## Claims

1. A sealing material sheet for a solar-cell module, which is a multi-layered sheet having a core layer and a skin layer, wherein
the core layer includes, in a content ratio with respect to the whole resin components in the core layer, polypropylene at 5% by mass to 40% by mass and low-density polyethylene having a density of 0.910 g/cm³ to 0.940 g/cm³ at 60% by mass to 95% by mass,
the polypropylene having an MFR ranging from 5 g/10 min to 125 g/10 min at a temperature of 230°C and a load of 2.16 kg,
the skin layer includes low-density polyethylene having a density of 0.880 g/cm³ to 0.910 g/cm³ at 80% by mass to 100% by mass in a content ratio with respect to whole resin components in the skin layer but does not include polypropylene, and
a thickness of the sealing material sheet is 200 µm to 400 µm.

2. The sealing material sheet according to claim 1, wherein a thickness of the sealing material sheet is 250 µm to 350 µm.

3. The sealing material sheet according to claim 1 or 2, which is a multi-layered sheet having a three-layered structure of skin/core/skin, wherein
a colored pigment is included in one skin layer and/or a core layer, and
a colored pigment is not included in an outermost surface of the other skin layer.

4. A sealing material sheet for a solar-cell module, which is a multi-layered sheet having a core layer and a skin layer, wherein
a content of low-density polyethylene having a density of 0.910 g/cm³ to 0.940 g/cm³ is 60% by mass to 95% by mass in a content ratio with respect to whole resin components in the core layer,
the skin layer includes low-density polyethylene having a density of 0.880 g/cm³ to 0.910 g/cm³ at 80% by mass to 100% by mass in a content ratio with respect to whole resin components in the skin layer,
a thickness of the sealing material sheet is 200 µm to 400 µm, and
in a thermomechanical analysis (TMA) curve which is obtained in a TMA test under the following conditions and indicates relationship between a predetermined temperature range and an indentation depth of a needle into the sealing material sheet,
the indentation depth of a needle at a temperature of 150°C in the TMA curve is 20% to 90% of a film thickness of the sealing material sheet:
TMA test: a ϕ10 mm sealing material sheet is set in a TMA apparatus, and a constant pressure of an indentation pressure 50 kPa is applied to a ϕ1 mm needle, a temperature is raised from room temperature to 150°C at a rate of temperature rise of 5°C/min, and an indentation depth of the needle at that time is measured.

5. The sealing material sheet according to claim 4, wherein the core layer of the sealing material sheet includes polypropylene at 15% by mass to 40% by mass with respect to whole resin components in a core layer composition, the polypropylene having an MFR ranging from 5 g/10 min to 125 g/10 min at a temperature of 230°C and a load of 2.16 kg.

6. A sealing material-integrated rear-surface protecting sheet for a solar-cell module comprising the sealing material sheet according to any one of claims 1 to 5 and a rear-surface protecting sheet laminated in such a manner that the skin layer is exposed to an outermost layer side.

7. The sealing material-integrated rear-surface protecting sheet according to claim 6, wherein the rear-surface protecting sheet is constituted to include a polyethylene terephthalate layer and/or a hydrolysis resistant polyethylene terephthalate layer.

8. The sealing material-integrated rear-surface protecting sheet according to claim 6 or 7, wherein a thickness of the sealing material-integrated rear-surface protecting sheet is 300 µm to 600 µm.

9. A solar-cell module comprising the sealing material-integrated rear-surface protecting sheet according to any one of claims 6 to 8 laminated on a non-light receiving surface side of a solar cell element in such a manner that the skin layers face each other.

## Patentansprüche

1. Dichtungsmaterialbahn für ein Solarzellenmodul, welche eine Mehrschichtfolie mit einer Kernschicht und einer Hautschicht ist, wobei
die Kernschicht 5 Massen-% bis 40 Massen-% Polypropylen und 60 Massen-% bis 95 Massen-% Polyethylen niedriger Dichte mit einer Dichte von 0,910 g/cm³ bis 0,940 g/cm³ in einem Gehaltsverhältnis bezogen auf die gesamten Harzkomponenten in der Kernschicht einschließt,
das Polypropylen einen MFR-Wert im Bereich von 5 g/10 min bis 125 g/10 min bei einer Temperatur von 230 °C und einer Belastung von 2,16 kg aufweist,
die Hautschicht 80 Massen-% bis 100 Massen-% Polyethylen niedriger Dichte mit einer Dichte von 0,880 g/cm³ bis 0,910 g/cm³ in einem Gehaltsverhältnis bezogen auf die gesamten Harzkomponenten in der Hautschicht einschließt, aber nicht Polypropylen einschließt, und
eine Dicke der Dichtungsmaterialbahn 200 µm bis 400 µm beträgt.

2. Dichtungsmaterialbahn gemäß Anspruch 1, wobei eine Dicke der Dichtungsmaterialbahn 250 µm bis 350 µm beträgt.

3. Dichtungsmaterialbahn gemäß Anspruch 1 oder 2, welche eine Mehrschichtfolie mit einer dreischichtigen Struktur von Haut/Kern/Haut ist, wobei
ein farbiges Pigment in einer Hautschicht und/oder einer Kernschicht eingeschlossen ist, und
ein farbiges Pigment nicht in einer äußersten Oberfläche der anderen Hautschicht eingeschlossen ist.

4. Dichtungsmaterialbahn für ein Solarzellenmodul, welche eine Mehrschichtfolie mit einer Kernschicht und einer Hautschicht ist, wobei
ein Gehalt von Polyethylen niedriger Dichte mit einer Dichte von 0,910 g/cm³ bis 0,940 g/cm³ 60 Massen-% bis 95 Massen-% in einem Gehaltsverhältnis bezogen auf die gesamten Harzkomponenten in der Kernschicht beträgt,
die Hautschicht 80 Massen-% bis 100 Massen-% Polyethylen niedriger Dichte mit einer Dichte von 0,880 g/cm³ bis 0,910 g/cm³ in einem Gehaltsverhältnis bezogen auf die gesamten Harzkomponenten in der Hautschicht einschließt,
eine Dicke der Dichtungsmaterialbahn 200 µm bis 400 µm beträgt, und
in einer thermomechanischen Analyse (TMA)-Kurve, die in einem TMA Test unter den folgenden Bedingungen erhalten wird und eine Beziehung zwischen einem vorbestimmten Temperaturbereich und einer Eindringtiefe einer Nadel in die Dichtungsmaterialbahn anzeigt,
die Eindringtiefe einer Nadel bei einer Temperatur von 150 °C in der TMA-Kurve 20% bis 90% einer Filmdicke der Dichtungsmaterialbahn beträgt:
TMA Test: eine ϕ10 mm Dichtungsmaterialbahn wird in eine TMA Vorrichtung eingesetzt und ein konstanter Druck eines 50 kPa Eindringdrucks wird auf eine ϕ1 mm Nadel aufgebracht, eine Temperatur wird von Raumtemperatur auf 150 °C bei einer Temperaturanstiegsgeschwindigkeit von 5 °C/min angehoben und eine Eindringtiefe der Nadel zu dieser Zeit wird gemessen.

5. Dichtungsmaterialbahn gemäß Anspruch 4, wobei die Kernschicht der Dichtungsmaterialbahn 15 Massen-% bis 40 Massen-% Polypropylen bezogen auf die gesamten Harzkomponenten in einer Kernschichtzusammensetzung einschließt, wobei das Polypropylen einen MFR-Wert im Bereich von 5 g/10 min bis 125 g/10 min bei einer Temperatur von 230 °C und einer Belastung von 2,16 kg aufweist.

6. Dichtungsmaterial-integrierte rückseitige Schutzfolie für ein Solarzellenmodul, umfassend die Dichtungsmaterialbahn gemäß mindestens einem der Ansprüche 1 bis 5 und eine rückseitige Schutzfolie, die in so einer Weise laminiert sind, dass die Hautschicht an einer äußersten Schichtseite freiliegt.

7. Dichtungsmaterial-integrierte rückseitige Schutzfolie gemäß Anspruch 6, wobei die rückseitige Schutzfolie so aufgebaut ist, dass sie eine Polyethylenterephthalatschicht und/oder eine Hydrolyse-beständige Polyethylenterephthalatschicht einschließt.

8. Dichtungsmaterial-integrierte rückseitige Schutzfolie gemäß Anspruch 6 oder 7, wobei eine Dicke der Dichtungsmaterial-integrierten rückseitigen Schutzfolie 300 µm bis 600 µm beträgt.

9. Solarzellenmodul, umfassend die Dichtungsmaterial-integrierte rückseitige Schutzfolie gemäß mindestens einem der Ansprüche 6 bis 8, welche in so einer Weise auf eine nicht-Licht-empfangende Oberflächenseite eines Solarzellenelements laminiert ist, dass die Hautschichten einander gegenüberliegen.

## Revendications

1. Feuille de matériau d'étanchéité pour un module de cellules solaires, qui est une feuille multicouche présentant une couche centrale et une couche extérieure, dans laquelle
la couche centrale inclut, dans un rapport de contenu par rapport aux composants de résine totaux dans la couche centrale, du polypropylène à raison de 5 % en masse à 40 % en masse et du polyéthylène basse densité présentant une densité de 0,910 g/cm³ à 0,940 g/cm³ à raison de 60 % en masse à 95 % en masse,
le polypropylène présentant un indice de fluidité à chaud de 5g/10min à 125 g/10 min à une température de 230 °C et une charge de 2,16 kg,
la couche extérieure inclut du polyéthylène basse densité présentant une densité de 0,880 g/cm³ à 0,910 g/cm³ à raison de 80 % en masse à 100 % en masse dans un rapport de contenu par rapport aux composants de résine totaux dans la couche extérieure mais n'inclut pas de polypropylène, et
une épaisseur de la feuille de matériau d'étanchéité est de 200 µm à 400 µm.

2. Feuille de matériau d'étanchéité selon la revendication 1, dans laquelle une épaisseur de la feuille de matériau d'étanchéité est de 250 µm à 350 µm.

3. Feuille de matériau d'étanchéité selon la revendication 1 ou 2, qui est une feuille multicouche présentant une structure à trois couches de type extérieur/centre/extérieur, dans laquelle
un pigment coloré est inclus dans une couche extérieure et/ou une couche centrale, et
un pigment coloré n'est pas inclus dans une surface la plus extérieure de l'autre couche extérieure.

4. Feuille de matériau d'étanchéité pour un module de cellules solaires, qui est une feuille multicouche présentant une couche centrale et une couche extérieure, dans laquelle
une teneur en polyéthylène basse densité présentant une densité de 0,910 g/cm³ à 0,940 g/cm³ est de 60 % en masse à 95 % en masse dans un rapport de contenu par rapport aux composants de résine totaux dans la couche centrale,
la couche extérieure inclut du polyéthylène basse densité présentant une densité de 0,880 g/cm³ à 0,910 g/cm³ à raison de 80 % en masse à 100 % en masse dans un rapport de contenu par rapport aux composants de résine totaux dans la couche extérieure,
une épaisseur de la feuille de matériau d'étanchéité est de 200 µm à 400 µm, et
dans une courbe d'analyse thermomécanique (TMA) qui est obtenue dans un test de TMA dans les conditions suivantes et indique une relation entre une plage de températures prédéterminée et une profondeur de pénétration d'une aiguille dans la feuille de matériau d'étanchéité,
la profondeur de pénétration d'une aiguille à une température de 150 °C dans la courbe de TMA est de 20% à 90% d'une épaisseur de film de la feuille de matériau d'étanchéité :
test de TMA : une feuille de matériau d'étanchéité de ϕ10 mm est installée dans un appareil de TMA, et une pression constante d'une pression de pénétration de 50 kPa est appliquée à une aiguille de ϕ1 mm, une température est augmentée de la température ambiante à 150 °C à un rythme de montée de température de 5 °C/min, et une profondeur de pénétration de l'aiguille à ce moment est mesurée.

5. Feuille de matériau d'étanchéité selon la revendication 4, dans laquelle la couche centrale de la feuille de matériau d'étanchéité inclut du polypropylène à raison de 15 % en masse à 40% en masse par rapport aux composants de résine totaux dans une composition de couche centrale, le polypropylène présentant un indice de fluidité à chaud de 5g/10min à 125 g/10 min à une température de 230 °C et une charge de 2,16 kg.

6. Feuille de protection de surface arrière intégrée à un matériau d'étanchéité pour un module de cellules solaires comprenant la feuille de matériau d'étanchéité selon l'une quelconque des revendications 1 à 5 et une feuille de protection de surface arrière stratifiée de telle manière que la couche extérieure est exposée à un côté de couche la plus extérieure.

7. Feuille de protection de surface arrière intégrée à un matériau d'étanchéité selon la revendication 6, dans laquelle la feuille de protection de surface arrière est constituée pour inclure une couche de polyéthylène téréphtalate et/ou une couche de polyéthylène téréphtalate résistante à l'hydrolyse.

8. Feuille de protection de surface arrière intégrée à un matériau d'étanchéité selon la revendication 6 ou 7, dans laquelle une épaisseur de la feuille de protection de surface arrière intégrée à un matériau d'étanchéité est de 300 µm à 600 µm.

9. Module de cellules solaires comprenant la feuille de protection de surface arrière intégrée à un matériau d'étanchéité selon l'une quelconque des revendications 6 à 8 stratifiée sur un côté de surface ne recevant pas de lumière d'un élément à cellule solaire de telle manière que les couches extérieures se font face.
